# EUROPÄISCHE PATENTANMELDUNG

(11) **EP 0 981 155 A2**
(43) Veröffentlichungstag der Anmeldung: **23.02.2000**
(21) Anmeldenummer: 99115543.3
(22) Anmeldetag: 03.08.1999
(51) Int. Cl.: H01L 21/266, H01L 21/28, H01L 21/8238

(54) **Verfahren zur Herstellung einer Halbleiter-Isolationsschicht und eines diese Halbleiter-Isolationsschicht enthaltenden Halbleiterbauelements**

(30) Priorität: 18.08.1998 DE 19837395
(71) Anmelder: SIEMENS AKTIENGESELLSCHAFT, 80333 München (DE)
(72) Erfinder: Müller, Karlheinz, 84478 Waldkraiburg (DE)

(57) **Zusammenfassung**

Die vorliegende Erfindung schafft ein Verfahren zur Herstellung einer Halbleiter-Isolationsschicht mit den Schritten Bereitstellen eines Halbleitersubstrats (10); bereichsweises oder ganzflächiges Aufbringen einer Isolationaschicht (20) auf das Halbleitersubstrat (10); selektives Implantieren (I) von Verunreinigungen in mindestens ein vorbestimmtes Gebiet (40; 40') der Isolationsschicht; und selektives Ätzen der Isolationsschicht (20), wodurch eine Strukturierung der Isolationsschicht (20) entsprechend dem oder den Gebieten (40; 40') der selektiv implantierten Verunreinigungsionen erzeugt wird. Ebenso schafft die vorliegende Erfindung ein Verfahren zur Herstellung eines diese Halbleiter-Isolationsschicht enthaltenden Halbleiterbauelements.

## Beschreibung

Die vorliegende Erfindung betrifft ein Verfahren zur Herstellung einer Halbleiter-Isolationsschicht und eines diese Halbleiter-Isolationsschicht enthaltenden Halbleiterbauelements.

Isolationsschichten auf Substraten in Halbleiterbauelementen werden heutzutage in einer Reihe verschiedener Technologien hergestellt. Zwei bekannte Beispiele dafür sind die LOCOS-Technologie und die STI (Shallow Trench Isolation)-Technologie. Dabei soll unter Substrat eine Unterlage verstanden werden und nicht lediglich ein Wafersubstrat. Ein Substrat im vorliegend verwendeten Ausdruckssinn kann also ein Wafersubstrat, eine Epitaxiestruktur, eine Wanne in einem Wafersubstrat, eine Schaltung in einem Wafersubstrat etc. sein.

Als nachteilhaft bei den obigen bekannten Ansätzen hat sich die Tatsache herausgestellt, daß sie einen hohen Prozeßaufwand erfordern und die Isolationsschicht häufig anfällig gegenüber Spannungen und Streß in sich und zum Substrat ist, wobei letzteres insbesondere auf die LOCOS-Technologie zutrifft.

Daher ist es Aufgabe der vorliegenden Erfindung, ein verbessertes Verfahren zur Herstellung einer Halbleiter-Isolationsschicht und eines diese Halbleiterisolationsschicht enthaltenden Halbleiterbauelements anzugeben, durch das mit verhältnismäßig geringem Prozeßaufwand eine streßfreie stabile Isolation geschaffen werden kann.

Erfindungsgemäß wird diese Aufgabe durch das in Anspruch 1 angegebene Verfahren gelöst.

Das erfindungsgemäße Verfahren weist gegenüber den bekannten Lösungsansätzen den Vorteil auf, daß es eine Isolationsstruktur ohne Spannungen in einem einfachen und kostengünstigen Prozeß ermöglicht.

Die der vorliegenden Erfindung zugrundeliegende Idee besteht darin, daß durch ein selektives Ätzen einer Isolationsschicht auf einem Halbleitersubstrat eine Strukturierung der Isolationsschicht entsprechend Gebieten selektiv implantierter Verunreinigungsionen erzeugt wird.

In den Unteransprüchen finden sich vorteilhafte Weiterbildungen und Verbesserungen des in Anspruch 1 angegebenen Verfahrens.

Gemäß einer bevorzugten Weiterbildung ist das Halbleitersubstrat ein Silizium-Halbleitersubstrat. Dies ist der Üblichste Fall, doch keineswegs ist die vorliegende Erfindung darauf beschränkt, vielmehr sind andere Halbleitermaterialien ohne weiteres verwendbar.

Gemäß einer weiteren bevorzugten Weiterbildung ist die Isolationsschicht eine Siliziumdioxidschicht und vorzugsweise aus thermischem Oxid. Solch ein Oxid schafft eine gute Verbindung zum Substrat.

Gemäß einer weiteren bevorzugten Weiterbildung ist die Siliziumdioxidschicht eine auf dem Halbleitersubstrat befindliche Schicht aus thermischem Oxid und eine darüber aufgebrachte Schicht aus nicht-thermischem Oxid, insbesondere TEOS- oder LTO (Low Temperature)-Oxid. Solch ein Oxid schafft nicht nur eine gute Verbindung zum Substrat, sondern läßt sich auch mit hohen Abscheideraten aufbringen.

Gemäß einer weiteren bevorzugten Weiterbildung wird das selektive Implantieren unter Verwendung mindestens einer Maske, insbesondere einer Fotolackmaske, durchgeführt. Dies ist die gängige Art der Strukturierung beim Naß- und Trockenätzen, doch sind selbstverständlich auch andere Masken, wie z.B. Nitridmasken etc., verwendbar.

Gemäß einer weiteren bevorzugten Weiterbildung wird das selektive Implantieren unter verschiedenen Winkeln und/oder Energien und/oder Dosen durchgeführt. So lassen sich die Ätzgebiete genau strukturieren.

Gemäß einer weiteren bevorzugten Weiterbildung wird das selektive Implantieren und Ätzen derart durchgeführt wird, daß die Isolationsschicht in den implantierten Gebieten durch das Ätzen entfernt. Dies soll als Positivprozeß verstanden werden und stellt den bevorzugten Fall dar, bei dem die implantierten Ionen die Bindungsstruktur schwächen.

Gemäß einer weiteren bevorzugten Weiterbildung wird das selektive Implantieren und Ätzen derart durchgeführt wird, daß die Isolationsschicht in den implantierten Gebieten durch das Ätzen nicht entfernt. Dies soll als Negativprozeß verstanden werden und prozeßtechnisch etwas komplizierter, da in der Regel ein zusätzlicher Hochtemperaturprozeß erforderlich ist, um die eingelagerten Ionen stabil in die Bindungsstruktur einzubinden.

Gemäß einer weiteren bevorzugten Weiterbildung wird das selektive Implantieren und Ätzen derart durchgeführt wird, daß ein durch die Isolationsschicht bis zum Halbleitersubstrat durchgehendes Kontaktbereich gebildet wird, dessen Flanken beispielsweise stufenförmig ausgebildet sind.

Gemäß einer weiteren bevorzugten Weiterbildung wird durch die Implantation mindestens ein Element aus der Gruppe: Ar, N, O, B, As, P implantiert, wobei die Konzentration der Verunreinigungen die Ätzrate in dem betreffenden Gebiet festlegt. Dies bedeutet in der Regel, daß eine hohe Verunreinigungskonzentration gleichbedeutend ist mit einer hohen lokalen Ätzrate.

Das erfindungsgemäße Verfahren zur Herstellung eines die oben definierte Halbleiterisolationsschicht enthaltenden Halbleiterbauelements sieht folgende Strukturierung der auf das Halbleitersubstrat aufgebrachten Isolationsschicht vor: Bilden einer ersten Maske auf dem Halbleitersubstrat; selektives Implantieren von Verunreinigungsionen in ein erstes vorbestimmtes Gebiet entsprechend der ersten Maske der Isolationsschicht, wobei das Implantationsprofil entsprechend einem an der Oberflächen liegenden Ätzgebiet geringerer Dicke als die Dicke der Isolationschicht gewählt wird; selektives Ätzen der Isolationsschicht in dem ersten vorbestimmten Gebiet entsprechend der Maske; Bilden einer zweiten Maske auf dem Halbleitersubstrat; selektives Implantieren von Verunreinigungsionen in ein zweites vorbestimmtes Gebiet entsprechend der zweiten Maske der Isolationsschicht, wobei das Implantationsprofil entsprechend einem Ätzgebiet gleicher Dicke wie der Dicke der Isolationschicht gewählt wird; selektives Ätzen der Isolationsschicht in dem ersten vorbestimmten Gebiet entsprechend der Maske zum Freilegen des Halbleitersubstrats; ganzflächiges Aufbringen einer leitenden Schicht auf die resultierende Struktur; und Polieren, insbesondere chemisch-mechanisches Polieren, der leitenden Schicht auf im wesentlichen die Dicke der Isolatorschicht.

Diese Verfahrensweise schafft Kontaktbereiche, Dickisolationsbereiche und Dünnisolationsbereiche mit in die Isola- tionsschicht eingelagerten, planarisierten Leiterbahnen der leitenden Schicht, welche über die Kontaktbereiche mit dem Substrat in Verbindung stehen.

Gemäß einer weiteren bevorzugten Weiterbildung findet ein Strukturieren der leitenden Schicht statt.

Gemäß einer weiteren bevorzugten Weiterbildung wird ein Feldeffekttransistor mit einem Kanalwannengebiet im zweiten vorbestimmten Gebiet entsprechend der zweiten Maske, einer darüberliegenden Gateisolatorschicht und Source- und Draingebieten im daran angrenzenden Bereich des Halbleitersubstrats.

Gemäß einer weiteren bevorzugten Weiterbildung erfolgt ein Bilden der ersten Maske auf dem Halbleitersubstrat entsprechend einem hantelförmigen Gebiet; ein Bilden der zweiten Maske auf dem Halbleitersubstrat entsprechend einem jeweiligen Gebiet in den Hanteltellern des hantelförmigen Gebiets entsprechend der ersten Maske; und ein Bilden eines jeweiligen Feldeffekttransistors mit einem Kanalwannengebiet im jeweiligen Gebiet entsprechend der zweiten Maske, einer darüberliegenden Gateisolatorschicht und Source- und Draingebieten im daran angrenzenden Bereich des Halbleitersubstrats; wobei die leitende Schicht, welche über den Hantelsteg verläuft, die beiden Gateanschlüsse der Feldeffekttransistoren verbindet. So läßt sich eine einfache Feldeffekttransistor-Inverterstruktur mit gemeinsamem Gateanschluß bilden.

Ausführungsbeispiele der Erfindung sind in den Zeichnungen dargestellt und in der nachfolgenden Beschreibung näher erläutert.

Es zeigen:
- Fig. 1a-c: verschiedene Prozeßstadien einer ersten Ausführungsform des erfindungsgemäßen Verfahrens im Querschnitt;
- Fig. 2: eine schematische Darstellung verschiedener Implantationsprofile zur Verwendung bei dem erfindungsgemäßen Verfahren;
- Fig. 3a-f: verschiedene Prozeßstadien einer zweiten Ausführungsform des erfindungsgemäßen Verfahrens zur Herstellung eines diese Halbleiterisolationsschicht enthaltenden Halbleiterbauelements in Form eines Feldeffekttransistor-Inerters im Querschnitt.

In den Figuren bezeichnen gleiche Bezugszeichen gleiche oder funktionsgleiche Elemente.

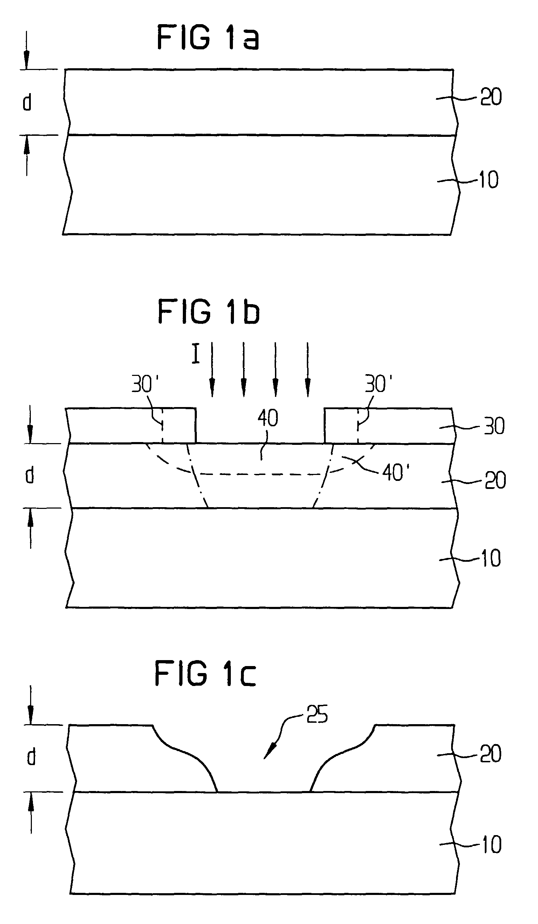

Fig. 1a-c zeigen verschiedene Prozeßstadien einer ersten Ausführungsform des erfindungsgemäßen Verfahrens im Querschnitt.

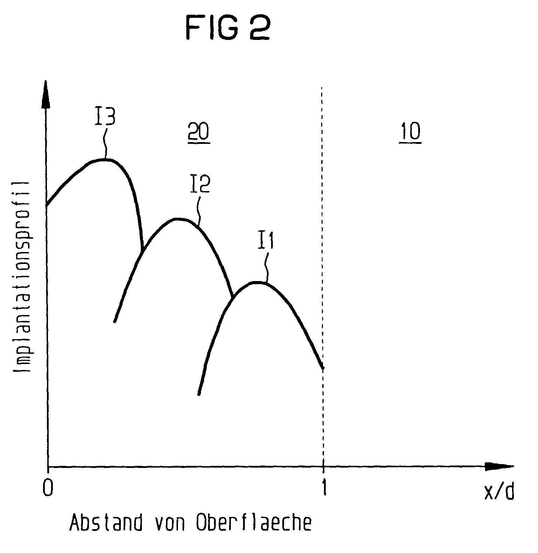

In Fig. 1a-c und 2 bezeichnen 10 ein Halbleitersubstrat aus Silizium, 20 eine Isolationsschicht in Form einer Oxidschicht, 30, 30' eine jeweilige Maske aus Fotolack, 40, 40' ein jeweiliges Implantationsgebiet entsprechend der Maske 30 bzw. 30', d die Dicke der Isolationsschicht, 25 ein Kontaktbereich und I, I1-3 jeeilige Ionenimplantationen.

Zunächst wird, wie in Fig. 1a gezeigt, das Halbleitersubstrats 10 ganzflächig mit der Isolationsschicht 20 in Form der Oxidschicht versehen. Dies geschieht durch Bilden eines thermischen Oxids oder eines Sandwiches aus thermischem Oxid als unterer Schicht und einer darüber aufgebrachten Schicht aus nicht-thermischem Oxid, insbesondere TEOS- oder LTO-Oxid.

Dann wird auf bekannte Art und Weise, wie in Fig. 1b gezeigt, die erste Maske 30 aus Fotolack auf der Oxidschicht 20 gebildet, welche einen entsprechenden ersten Implantationsbereich 40 definiert. Es folgt ein selektives Implantieren I von Verunreinigungen, z.B. Bor, in den Implantationsbereich 40. Anschließend wird die Maske 30 entfernt.

Danach wird auf bekannte Art und Weise, wie in Fig. 1b gezeigt, die zweite Maske 30' aus Fotalack auf der Oxidschicht 20 gebildet, welche einen entsprechenden ersten Implantationsbereich 40' definiert. Es folgt in analoger Weise ein selektives Implantieren I von Verunreinigungen, z.B. Bor, in den Implantationsbereich 40'. Anschließend wird die Maske 30' entfernt.

Als nächstes erfolgt ein selektives Ätzen der Oxidschicht 20, wodurch eine Strukturierung der Isolationsschicht 20 entsprechend den Bereichen 40; 40' der selektiv implantierten Verunreinigungsionen erzeugt wird. Das Ätzen wird naßchemisch oder trockenchemisch mit einem isotropen Ätzverfahren durchgeführt, wobei die Oxidschicht 20 in den implantierten Gebieten durch das Ätzen entfernt wird, da die implantierten Borionen die Bindungsstruktur schwächen.

Als Resultat der Ätzung stellt sich die in Fig. 1c gezeigte Struktur ein, in der der durch die Oxidschicht 20 bis zum Halbleitersubstrat 10 durchgehende Kontaktbereich 25 gebildet ist, dessen Flanken stufenförmig (2 Stufen) ausgebildet sind.

Abhängig davon, was für eine konkrete Struktur im Substrat vorliegt, können anschließend übliche retrograde Wannenprozesse, Füllprozesse, Strukturierungsprozesse etc. zum Ausbilden einer Halbleiterbauelementstruktur vorgenommen werden.

Fig. 2 zeigt eine schematische Darstellung verschiedener Implantationsprofile zur Verwendung bei dem erfindungsgemäßen Verfahren, also die Konzentration der implantierten Ionen in Abhängigkeit von dem Verhältnis Eindringtiefe x zu Dicke d der Oxidschicht 20 für die drei Implantationen I1-3.

Die in Fig. 2 gezeigte Struktur ergäbe beispielsweise beispielsweise bei der in Fig. 1a-c gezeigten Struktur ein durch die Oxidschicht 20 bis zum Halbleitersubstrat 10 durchgehender Kontaktbereich 25 gebildet ist, dessen Flanken stufenförmig (3 Stufen) ausgebildet sind.

Allgemein kann das selektive Implantieren unter verschiedenen Winkeln und/oder Energien und/oder Dosen durchgeführt werden, um beliebig gestaltete Ätzstrukturen in der Oxidschicht 20 zu realisieren.

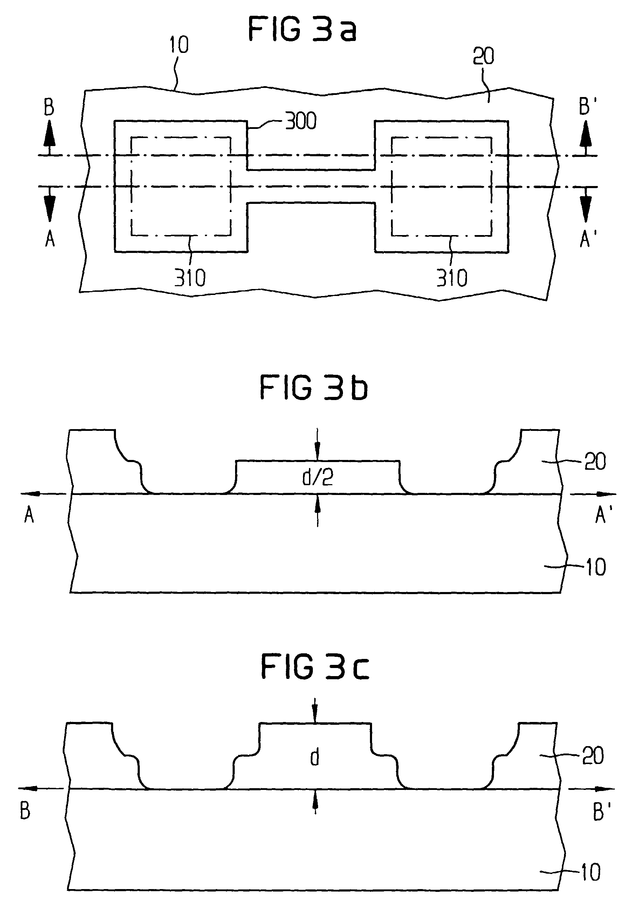

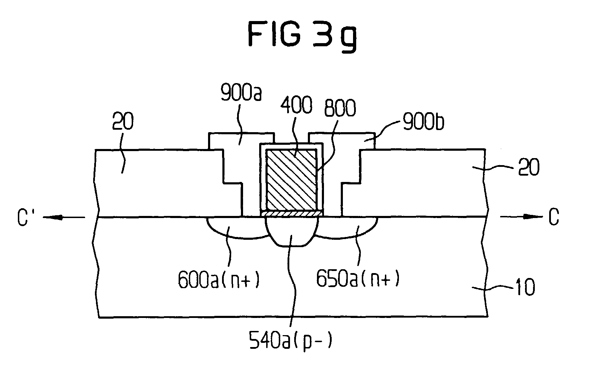

Fig. 3a-f zeigen verschiedene Prozeßstadien einer zweiten Ausführungsform des erfindungsgemäßen Verfahrens zur Herstellung eines diese Halbleiterisolationsschicht enthaltenden Halbleiterbauelements in Form eines Feldeffekttransistor-Inerters im Querschnitt.

In Fig. 3a-f bezeichnen zusätzlich zu den bereits eingeführten Bezugszeichen A,A'; B,B'; C,C' Schnittrichtungen, 300 eine erste Maske, 310 eine zweite Maske, 311 bzw. 312 eine dritte Maske, 400 eine leitende Schicht aus Polysilizium, 500 eine Gateisolationsschicht (z.B. Oxid), 540a,b ein jeweiliges Kanalwannengebiet, 600a, 650a ein jeweiliges Sourcegebiet, 600b, 650b ein jeweiliges Draingebiet, 700a-d eine Maske für Strukturierung der leitenden Schicht 400, 800 eine Spacerisolation von der leitenden Schicht (Gatekontaktisolation) und 900a,b einen jeweiligen Source/Drain-Kontakt.

Bei dem in Fig. 3a-f gezeigten Verfahrensbeispiel handelt es sich um ein Verfahren zur Herstellung einer Feldeffekttransistorstruktur, das die oben erwähnte Halbleiterisolationsschicht verwendet.

Es erfolgt zunächst das Bereitstellen des Si-Halbleitersubstrats 10 und dann ein ganzflächiges Aufbringen der Oxidschicht 20 auf das Halbleitersubstrat 10 mit einer vorbestimmten Dicke d, z.B. 5-10 µm.

Darauf erfolgt das Bilden einer ersten Maske 300 auf dem Halbleitersubstrat 10 mit einer hantelförmigen Gestalt. Es wird dann ein selektives Implantieren von Bor-Verunreinigungsionen in das Hantelgebiet entsprechend der ersten Maske 300 durchgeführt, wobei das Implantationsprofil entsprechend einem an der Oberflächen liegenden Ätzgebiet geringerer Dicke, nämlich d/2, als die Dicke d der Oxidschicht 20 gewählt wird.

Dann wird im entsprechenden Bereich ein Dünnoxid mit einer Dicke d/2 gebildet, indem ein selektives Ätzen der Oxidschicht 20 in dem Hantelgebiet entsprechend der Maske 300 erfolgt.

Darauf erfolgt das Bilden einer ersten Maske 310 auf dem Halbleitersubstrat 10 mit Öffungen einer quadratischen Gestalt, welche in den Hanteltellern liegen. Es wird dann ein selektives Implantieren von Bor-Verunreinigungsionen in das Hantelgebiet entsprechend der ersten Maske 300 durchgeführt, wobei das Implantationsprofil entsprechend einem bis zum Halbleitersubstrat 10 durchgehenden Ätzgebiet gleicher Dicke, nämlich d, wie die Dicke d der Oxidschicht 20 gewählt wird.

Dann wird im entsprechenden Bereich das Oxid vollständig entfernt, indem ein selektives Ätzen der Oxidschicht 20 in dem Hantelgebiet entsprechend der Maske 300 erfolgt.

Dies ergibt die in Fig. 3a-c gezeigte Struktur, wobei Fig. 3b und 3c Schnitte entlang der Linien A-A' bzw. B-B' von Fig. 3a sind.

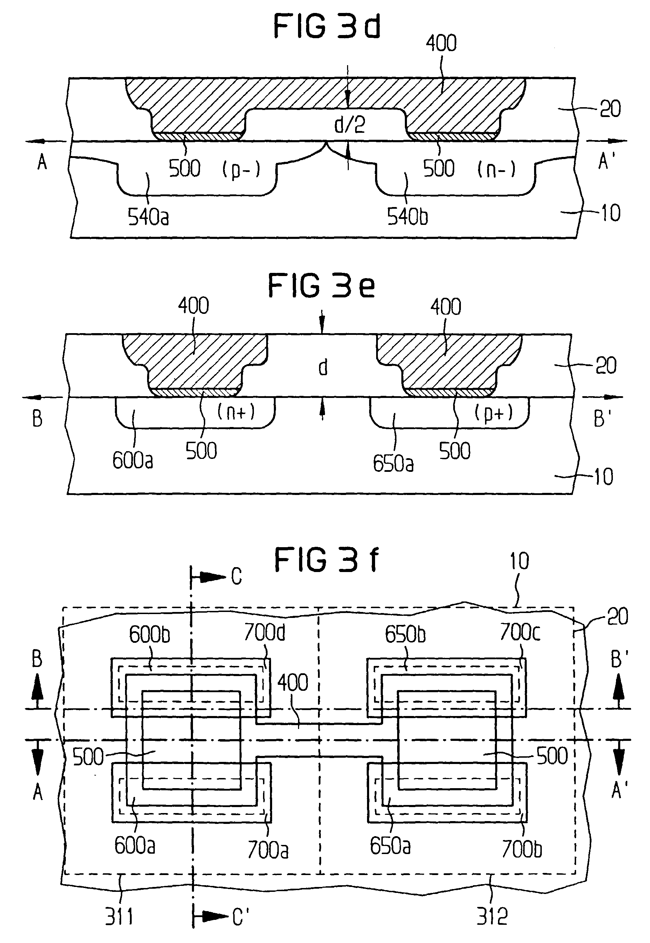

Wie in Fig. 3c und 3d gezeigt, welche Fig. 3b und 3c in einem späteren Prozeßstadium entsprechen, erfolgt weiterhin das Bilden eines jeweiligen p- bzw. n-Feldeffekttransistors mit einem p⁻-Kanalwannengebiet 540 a und einem n⁻-Kanalwannengebiet 540 b im jeweiligen quadratischen Gebiet entsprechend einer dritten Maske 311, 312, einer darüberliegenden Gateisolatorschicht 500 und n⁺/p⁺-Source- und Draingebieten 600 a,b bzw. 650 a,b im daran angrenzenden Bereich des Halbleitersubstrats 10. Dies geschieht durch bekannte Implantationsprozesse bzw. retrograde Wannenprozesse.

Dann erfolgt ein ganzflächiges Aufbringen der leitenden Schicht 400 aus Polysilizium auf die resultierende Struktur und ein chemisch-mechanisches Polieren, der leitenden Schicht 400 auf im wesentlichen die Dicke d der Oxidschicht 20.

Die ergibt eine Struktur zweier nebeneinanderliegender Feldeffekttransistoren, wobei die leitende Schicht 400 aus Polysilizium, welche über den Hantelsteg (Oxiddicke d/2) verläuft, die beiden Gateanschlüsse der Feldeffekttransistoren verbindet.

Als nächstes erfolgt, wie in Fig. 3e gezeigt, ein Strukturieren der leitenden Schicht 400 aus Polysilizium mittels einer weiteren Fotolackmaske 700a-d, welche im gezeigten Bereich vier rechteckige Öffnungen aufweist, um die Kontaktanschlüsse zu den n⁺/p⁺-Source- und Draingebieten 600 a,b bzw. 650 a,b zu bilden.

Schließlich werden, wie in Fig. 3f gezeigt, die Gatekontakte aus dem Polysilizium 400 durch eine übliche Spacerisolation isoliert und die Source/Drain-Kontakte 900a,b durch eine Polysiliziumfüllung und Strukturierung gebildet. Die weiteren Prozeßschritte, wie z.B. Abscheidung einer weiteren Isolatorschicht und Metallschicht und deren Strukturierung, sind Standard und müssen hier nicht weiter erläutert werden.

Obwohl in Fig. 3f nicht gezeigt, muß die leitende Schicht 400 an ihrer Oberfläche siliziert werden (Dualgate-Technik) oder das Gatepolysilizium mit phosphordotiert werden, um eine niederohmsche elektrische Verbindung zu erhalten.

Obwohl die vorliegende Erfindung vorstehend anhand bevorzugter Ausführungsbeispiele beschrieben wurde, ist sie darauf nicht beschränkt, sondern auf vielfältige Art und Weise modifizierbar.

Obwohl in den obigen Beipielen Bor implantiert wurde, kann die Implantation auch mit beliebigen anderen Ionen durchgeführt werden, welche die gewünschte Bindungsschwächung bzw. -verstärkung hervorrufen. Die Auswahl der Ionenart hängt insbeondere von den verfügbaren Ätzprozessen und der Substratdotierung ab. Ggfs. ist darauf zu achten, daß kein Ätzangriff auf das Substrat stattfindet.

Insbesondere können die Source/Drain-Kontakte 900a,b auch durch eine Metallfüllung (z.B. Wolfram) und Planarisierung gebildet werden. Eine weitere Alternative besteht in einer Auffüllung der Öffnungen mit Oxid und einem speziellen Kontaktlochprozeß, wie er in der Planartechnologie üblich ist.

Auch ist es möglich, die Drain/Source-Bereiche durch Ausdiffusion aus den Source/Drain-Kontakten 900a,b herzustellen, wenn diese entsprechend dotiert werden. Dies schafft sehr flache Drain/Source-Bereiche.

Statt der Verwendung der oben erwähnten zweiten Maske kann mit der gleichen Maske weiterverfahren werden, wenn nach dem Ätzen (mit Lack) der Lack weiter verfließen gelassen wird.

## Patentansprüche

1. Verfahren zur Herstellung einer Halbleiter-Isolationsschicht mit den Schritten:
Bereitstellen eines Halbleitersubstrats (10);
bereichsweises oder ganzflächiges Aufbringen einer Isolationsschicht (20) auf das Halbleitersubstrat (10);
selektives Implantieren (I) von Verunreinigungen in mindestens ein vorbestimmtes Gebiet (40; 40') der Isolationsschicht; und
selektives Ätzen der Isolationsschicht (20), wodurch eine Strukturierung der Isolationsschicht (20) entsprechend dem oder den Gebieten (40; 40') der selektiv implantierten Verunreinigungsionen erzeugt wird.

2. Verfahren nach Anspruch 1, dadurch gekennzeichnet, daß das Halbleitersubstrat (10) ein Silizium-Halbleitersubstrat ist.

3. Verfahren nach Anspruch 2, dadurch gekennzeichnet, daß die Isolationsschicht (20) eine Siliziumdioxidschicht, vorzugsweise aus thermischem Oxid, ist.

4. Verfahren nach Anspruch 3, dadurch gekennzeichnet, daß die Siliziumdioxidschicht eine auf dem Halbleitersubstrat (10) befindliche Schicht aus thermischem Oxid und eine darüber aufgebrachte Schicht aus nicht-thermischem Oxid, insbesondere TEOS- oder LTO-Oxid.

5. Verfahren nach einem der vorhergehenden Ansprüche, dadurch gekennzeichnet, daß das selektive Implantieren unter Verwendung mindestens einer Maske (30; 30'), insbesondere einer Fotolackmaske, durchgeführt wird.

6. Verfahren nach einem der vorhergehenden Ansprüche, dadurch gekennzeichnet, daß das selektive Implantieren unter verschiedenen Winkeln und/oder Energien und/oder Dosen durchgeführt wird.

7. Verfahren nach einem der vorhergehenden Ansprüche, dadurch gekennzeichnet, daß das selektive Implantieren und Ätzen derart durchgeführt wird, daß die Isolationsschicht (20) in den implantierten Gebieten durch das Ätzen entfernt wird.

8. Verfahren nach einem der vorhergehenden Ansprüche, dadurch gekennzeichnet, daß das selektive Implantieren und Ätzen derart durchgeführt wird, daß die Isolationsschicht (20) in den implantierten Gebieten durch das Ätzen nicht entfernt wird.

9. Verfahren nach einem der vorhergehenden Ansprüche, dadurch gekennzeichnet, daß das selektive Implantieren und Ätzen derart durchgeführt wird, daß ein durch die Isolationsschicht (20) bis zum Halbleitersubstrat (10) durchgehender Kontaktbereich (25) gebildet wird.

10. Verfahren nach einem der vorhergehenden Ansprüche, dadurch gekennzeichnet, daß durch die Implantation mindestens ein Element aus der Gruppe: Ar, N, O, B, As, P implantiert wird und die Konzentration der Verunreinigungen die Ätzrate in dem betreffenden Gebiet festlegt.

11. Verfahren zur Herstellung eines die Halbleiterisolationsschicht nach mindestens einem der vorhergehenden Ansprüche enthaltenden Halbleiterbauelements mit den Schritten:
Bereitstellen des Halbleitersubstrats (10);
ganzflächiges Aufbringen der Isolationsschicht (20) auf das Halbleitersubstrat (10) mit einer vorbestimmten Dicke (d);
Bilden einer ersten Maske (300) auf dem Halbleitersubstrat (10);
selektives Implantieren (I) von Verunreinigungsionen in ein erstes vorbestimmtes Gebiet entsprechend der ersten Maske (300) der Isolationsschicht (20), wobei das Implantationsprofil entsprechend einem an der Oberflächen liegenden Ätzgebiet geringerer Dicke (d/2) als die Dicke (d) der Isolationschicht (20) gewählt wird;
selektives Ätzen der Isolationsschicht (20) in dem ersten vorbestimmten Gebiet entsprechend der Maske (300);
Bilden einer zweiten Maske (310) auf dem Halbleitersubstrat (10);
selektives Implantieren (I) von Verunreinigungsionen in ein zweites vorbestimmtes Gebiet entsprechend der zweiten Maske (300) der Isolationsschicht (20), wobei das Implantationsprofil entsprechend einem Ätzgebiet gleicher Dicke (d/2) wie der Dicke (d) der Isolationschicht (20) gewählt wird;
selektives Ätzen der Isolationsschicht (20) in dem ersten vorbestimmten Gebiet entsprechend der Maske (300) zum Freilegen des Halbleitersubstrats (10);
ganzflächiges Aufbringen einer leitenden Schicht (400) auf die resultierende Struktur; und
Polieren, insbesondere chemisch-mechanisches Polieren, der leitenden Schicht (400) auf im wesentlichen die Dicke (d) der Isolationsschicht (20).

12. Verfahren nach Anspruch 11, gekennzeichnet durch den Schritt:
Strukturieren der leitenden Schicht (400).

13. Verfahren nach Anspruch 11 oder 12, gekennzeichnet durch die Schritte:
Bilden eines Feldeffekttransistors mit einem Kanalwannengebiet (540a,b) im zweiten vorbestimmten Gebiet entsprechend der zweiten Maske (310), einer darüberliegenden Gateisolatorschicht (500) und Source- und Draingebieten (600a,b; 650a,b) im daran angrenzenden Bereich des Halbleitersubstrats (10).

14. Verfahren nach Anspruch 11 oder 12, gekennzeichnet durch die Schritte:
Bilden der ersten Maske (300) auf dem Halbleitersubstrat (10) entsprechend einem hantelförmigen Gebiet;
Bilden der zweiten Maske (310) auf dem Halbleitersubstrat (10) entsprechend einem jeweiligen Gebiet in den Hanteltellern des hantelförmigen Gebiets entsprechend der ersten Maske (300); und
Bilden eines jeweiligen Feldeffekttransistors mit einem Kanalwannengebiet (540a,b) im jeweiligen Gebiet entsprechend der zweiten Maske (310), einer darüberliegenden Gateisolatorschicht (500) und Source- und Draingebieten (600a,b; 650a,b) im daran angrenzenden Bereich des Halbleitersubstrats (10);
wobei die leitende Schicht (400), welche über den Hantelsteg verläuft, die beiden Gateanschlüsse der Feldeffekttransistoren verbindet.

15. Verfahren nach Anspruch 13 oder 14, gekennzeichnet durch die Schritte:
Strukturieren der leitenden Schicht (400) mittels einer weiteren Maske (700a-d), um Öffnungen für die Kontaktanschlüsse (900a,b) zu den Source- und Draingebieten (600 a,b; 650 a,b) zu bilden.

16. Verfahren nach Anspruch 15, gekennzeichnet durch die Schritte:
Bilden der Kontaktanschlüsse (900a,b) mit dotiertem Polysilizium;
Planarisieren der Kontaktanschlüsse (900a,b) vorzugsweise durch chemisch-mechanisches Polieren; und
Ausdiffundieren der Dotierung der Kontaktanschlüsse (900a,b) zur Fertigstellung der Source- und Draingebiete (600a,b; 650a,b).
